# EUROPÄISCHE PATENTSCHRIFT

(11) **EP 0 793 110 B1**
(45) Veröffentlichungstag und Bekanntmachung des Hinweises auf die Patenterteilung: **25.10.2006**
(21) Anmeldenummer: 97102119.1
(22) Anmeldetag: 11.02.1997
(51) Int. Cl.: G01R 27/28

(54) **Verfahren zum Messen von elektronischen Messobjekten mittels eines Netzwerkanalysators**
Method for measuring an electronic object with a network analyser
Procédé de mesure d'un objet électronique utilisant un analyseur de réseau

(30) Priorität: 24.02.1996 DE 19606986
(43) Veröffentlichungstag der Anmeldung: 03.09.1997
(73) Patentinhaber: Rohde & Schwarz GmbH & Co. KG, 81671 München (DE); Compact Software, Inc., Paterson, NJ 07504 (US)
(72) Erfinder: Evers, Christian, Dipl.-Ing., 85551 Kirchheim (DE); Behrendt, Detlef, Dipl.-Ing., 85567 Grafing (DE); Simon, Jochen, Dr.Ing., 81547 München (DE); Rohde, Ulrich L., Prof.Dr.Dr.Ing.H.C., NJ 07458 (US)
(74) Vertreter: Körfer, Thomas

(56) Entgegenhaltungen:
- US-A- 5 047 725
- US-A- 5 321 364
- VAN HAUWERMEIREN L ET AL: "A NEW DE-EMBEDDING TECHNIQUE FOR ON-BOARD STRUCTURES APPLIED TO THE BANDWIDTH MEASUREMENT OF PACKAGES" IEEE TRANSACTIONS ON COMPONENTS,HYBRIDS,AND MANUFACTURING TECHNOLOGY, Bd. 16, Nr. 3, 1.Mai 1993, Seiten 300-303, XP000393472
- EUL H J ET AL: "EXPERIMENTAL RESULTS OF NEW SELF-CALIBRATION PROCEDURES FOR NETWORK ANALYZERS" PROCEEDINGS OF THE EUROPEAN MICROWAVE CONFERENCE, BUDAPEST, SEPT. 10 - 13, 1990, Bd. 2, 10.September 1990, MICROWAVE EXHIBITIONS AND PUBLISHERS, Seiten 1461-1466, XP000327062
- HONG DAI ET AL: "A DECOMPOSITION APPROACH FOR PARAMETER IDENTIFICATION IN LARGE SCALE NETWORKS" PROCEEDINGS OF THE INTERNATIONAL SYMPOSIUM ON CIRCUITS AND SYSTEMS, NEW ORLEANS, MAY 1 - 3, 1990, Bd. 3 OF 4, 1.Mai 1990, INSTITUTE OF ELECTRICAL AND ELECTRONICS ENGINEERS, Seiten 2409-2412, XP000163689

## Beschreibung

Bei der Fabrikation und Wareneingangsprüfung von elektronischen Netzwerken, beispielsweise elektronischen Bauelementen wie Transistoren, Filter und dergleichen, ist es erforderlich, diese vor ihrem Einbau in Geräte genau zu messen. Für ein Messen der charakteristischen Daten solcher Netzwerke in einem vorgegebenen breiten Frequenzbereich eignen sich insbesondere Netzwerkanalysatoren. Der Netzwerkanalysator kann dabei beispielsweise als Reflektometer mit nur einem Meßtor ausgebildet sein, er weist im allgemeinen jedoch zwei Meßtore auf und ist als sogenannter vektorieller Netzwerkanalysator zum Messen der Ein- bzw. Zweitor-Parameter eines Meßobjekts nach Betrag und Phase aufgebaut (z.B. nach US 4 982 164).

Für eine genaue Messung ist es erforderlich, daß der Netzwerkanalysator durch Anschalten von Kalibrierstandards vorher kalibriert wird. Dabei werden beispielsweise drei Kalibrierstandards, von denen sämtliche Parameter bekannt sind, nacheinander an die Meßtore des Netzwerkanalysators angeschaltet und jeweils die Streu (S)-Parameter (Transmissions- und Reflexions-Parameter) gemessen und in Matrixform in einem Speicher des Netzwerkanalysators abgespeichert. Die so durch Kalibrieren ermittelten Systemfehler-Korrekturdaten in Matrixform können dann nach einem im Netzwerkanalysator vorhandenen Algorithmus bei der anschließenden Meßwertkorrektur berücksichtigt werden.

Die zu messenden elektronischen Netzwerke wie Bauelemente müssen während ihres Betriebes und damit auch während des Messens meist in ein lineares Zusatznetzwerk eingebettet werden, d.h. ein zu messendes Bauelement muß während des Betriebes beispielsweise eingangsseitig und/oder ausgangsseitig über ein Anpaßnetzwerk betrieben werden oder es muß parallel und /oder in Reihe zum Bauelement eine andere für den Betrieb erforderliche Zusatzschaltung vorgesehen sein. Ein typisches Beispiel ist ein Transistor, der in einem Hochfrequenzverstärker eingesetzt werden soll, der ein- und ausgangsseitig eine Impedanz von 50 Ω aufweisen soll. Da die Ein- und Ausgangsimpedanz des Transistors meist nicht 50 Ω beträgt, muß am Ein- und Ausgang eine entsprechende Anpaßschaltung vorgesehen werden. Für die Wareneingangsprüfung eines solchen Transistors beim Hersteller des Verstärkers ist es daher sinnvoll eine Meßfassung zu verwenden, in welcher diese speziellen Anpaßschaltungen eingebaut sind. Beim Messen eines in eine solche Meßfassung eingesetzten Transistors mittels eines kalibrierten Netzwerkanalysators erhält man somit die charakteristischen Daten (z.B. S-Parameter) für den gesamten Verstärker einschließlich Anpaßschaltung. Der Vorteil solcher Messungen ist, daß die gegebenen Spezifikationen für den Gesamtverstärker nicht in Toleranzgrenzen für den unbeschalteten Transistor umgerechnet werden müssen, sondern unmittelbar verwendet werden können.

Dieses an sich vorteilhafte aufeinanderfolgende Messen von Bauelementen in großer Stückzahl besitzt jedoch den Nachteil, daß für mehrere gleichartige Meßplätze eines Prüffeldes möglichst gleiche Meßfassungen vorgesehen sein müssen und die jeweils integrierten Anpaßschaltungen enge Toleranzen einhalten müssen. Wenn außerdem das gleiche Bauelement für verschiedene Anwendungsfälle mit unterschiedlichen Zusatzschaltungen betrieben werden soll, so müssen für jeden dieser Anwendungsfälle jeweils gesonderte Meßfassungen vorhanden sein. Je nach Meßobjekt und dessen Anwendungsbereich muß deshalb in einem Prüffeld eine Vielzahl von verschiedenen Meßfassungen vorhanden sein, die noch dazu unter sich mit engen Toleranzen gleich sein müssen. Dadurch werden solche Messungen sehr aufwendig und teuer.

Es ist daher Aufgabe der Erfindung, ein Verfahren zum Messen von elektronischen Meßobjekten mittels eines Netzwerkanalysators aufzuzeigen, bei dem auf einfache Weise solche zum Betrieb des Meßobjekts erforderliche Zusatzschaltungen berücksichtigt werden können.

Diese Aufgabe wird ausgehend von einem Verfahren laut Oberbegriff des Hauptanspruches durch dessen kennzeichnende Merkmale gelöst. Vorteilhafte Weiterbildungen insbesondere auch bezüglich des einfachen Messens der charakteristischen Daten einer solchen Zusatzschaltung ergeben sich aus den Unteransprüchen.

Zur Ermittlung der optimalen Dimensionierung einer Anpaßschaltung, die einem Meßobjekt vorgeschaltet werden soll, ist es an sich bekannt, zunächst in einem ersten Verfahrensschritt die Streuparameter des Meßobjekts mittels eines Netzwerkanalysators zu messen und damit dann in einem zweiten Verfahrensschritt auf einem Rechner die Parameter der Anpaßschaltung zu berechnen, die eine optimale Anpassung ermöglichen (US-PS 5 321 364). Eine Ermittlung von Systemfehlerkorrekturdaten des Netzwerkanalysators und eine Verknüpfung dieser mit den Daten der Anpaßschaltung ist hierbei nicht vorgesehen.

Für die Bestimmung der Streuparameter eines Meßobjektes, das auf einem Substrat zwischen Mikrostrip-Leitungen eingebettet ist, ist ein Kalibrierverfahren bekannt, bei dem mit Hilfe der Zeitbereichsmessung zunächst die Streuparameter der Gesamtschaltung (Mikrostrip-Leitungen einschließlich Meßobjekt) nach einem bekannten Kalibrierverfahren und anschließend die Streuparameter der Mikrostrip-Leitungen allein bestimmt werden; daraus werden dann die Streuparameter des Meßobjektes berechnet (van Hauwermeiren L. et al: "A new de-embedding technique for on-board structures applied to the bandwidth measurement of packages", IEEE Transactions on Components, Hybrids, and Manufacturing Technology, Bd. 16, nr. 3, 1. Mai 1993, Seiten 300-303).

Beim erfindungsgemäßen Verfahren wird die beim Betrieb des Meßobjekts erforderliche Zusatzschaltung nicht konkret realisiert, sondern während der Messung nur simuliert. Die charakteristischen Daten der Zusatzschaltung, die entweder an einer konkret aufgebauten Muster-Zusatzschaltung durch Messen gewonnen oder durch ein bekanntes Simulationsprogramm berechnet werden, werden beim erfindungsgemäßen Verfahren unmittelbar mit den Systemfehlerkorrekturdaten des Netzwerkanalystors verknüpft. Beim anschließenden Messen des Meßobjekts, das nicht mehr in ein konkret aufgebautes Zusatznetzwerk eingebettet ist, sondern das unmittelbar mit den Meßtoren des Netzwerkanalysators verbunden wird, ergeben sich nach der Systemfehlerkorrektur die Meßdaten dennoch so, als ob das Zusatznetzwerk vorhanden wäre. Das Zusatznetzwerk wird also nur simuliert und die Messung erfolgt mit einem virtuell mit dem Meßobjekt zusammengeschalteten Zusatznetzwerk. Damit sind bei dem oben erwähnten Anwendungsfall der Wareneingangsprüfung nur noch Universal-Meßfassungen erforderlich, in welche keine Zusatzschaltungen integriert sind. An einer beliebigen Vielzahl von Meßplätzen kann so jede beliebige Zusatzschaltung mit größter Genauigkeit beim Messen von beliebigen Meßobjekten berücksichtigt werden. Zum Wechseln einer Zusatzschaltung genügt es, einen anderen Simulations-Datensatz in den Netzwerkanalysator zu laden und mit den dort abgespeicherten Systemfehler-Korrekturdaten zu einer neuen Matrix zu verknüpfen.

Der überraschende Vorteil des erfindungsgemäßen Verfahrens ist vor allem darin zu sehen, daß für diese virtuelle Berücksichtigung eines Anpaßnetzwerkes der schon im Netzwerkanalysator implementierte Algorithmus zur Systemfehlerkorrektur benutzt wird, nach welchem ohne zusätzlichen Rechenaufwand pro Frequenzschritt des Netzwerkanalysators sofort eine entsprechende Korrektur der Meßwerte durchgeführt wird und zwar so schnell, daß damit praktisch Echtzeitmessungen durchgeführt werden können. Die zur Simulation des Zusatznetzwerkes erforderlichen Daten werden gleichzeitig mit den Systemfehlerkorrekturdaten bei der Messung berücksichtigt und die Meßzeit wird hierdurch also nicht verlängert.

Unter "charakteristische Daten" des Zusatznetzwerkes werden alle üblichen Matrixdarstellungen verstanden, also beispielsweise übliche Strom/Spannungs-Matrizen oder übliche Wellenmatrizen in Streuparameter (S)-oder Transmissions (T)-Parameterdarstellung. Das gleiche gilt für die Darstellung der Systemfehlerkorrekturdaten, auch hierfür sind all diese bekannten Matrixformen geeignet. Besonders vorteilhaft ist es, sowohl die Systemfehlerkorrekturdaten als auch die charakteristischen Daten des Zusatznetzwerkes in Transmissions (T)-Matrizenform darzustellen, da hiermit die neue Fehlerkorrektur/Simulations-Matrix auf einfache Weise unmittelbar durch Multiplikation der ursprünglichen Systemfehlerkorrektur (T)-Matrix mit der inversen T-Matrix des Zusatznetzwerkes bestimmt werden kann.

Die charakteristischen Daten der Zusatzschaltung können im einfachsten Fall nach einem an sich bekannten Simulationsprogramm berechnet werden, wie es beispielsweise in den Bedienhandbüchern des Programms SuperCompact der Firma Compact Software beschrieben ist. Mit einem solchen bekannten Simulationsprogramm kann das Verhalten einer beliebigen Hochfrequenzschaltung beispielsweise über einen in das Programm eingegebenen Stromlauf nachgebildet und als S-Matrix oder T-Matrix dargestellt werden. Eine solche durch Rechnung ermittelte Matrix kann dann unmittelbar mit der Systemfehlerkorrekturmatrix verknüpft werden.

In der Praxis läßt sich jedoch oftmals die optimale Dimensionierung einer solchen Zusatzschaltung nicht immer rein synthetisch durch Rechnung bestimmen, insbesondere bei sehr hohen Frequenzen, da bei solchen Simulationsprogrammen parasitäre Größen der Zusatzschaltung nicht berücksichtigt werden. In solchen Fällen ist es vorteilhaft, eine für ein spezielles Meßobjekt erforderliche Zusatzschaltung als Muster-Zusatznetzwerk konkret aufzubauen und dann experimentell dieses Muster-Anpaßnetzwerk zu messen und auf diese Weise die charakteristischen Daten der Zusatzschaltung zu bestimmen, die dann wieder rechnerisch mit den Systemfehlerkorrekturdaten der Kalibrierung verknüpft werden. Ein solches unmittelbares Ausmessen der charakteristischen Daten eines Zusatznetzwerkes an einem entsprechenden Muster ist vor allem dann von Vorteil, wenn die Zusatzschaltung beispielsweise in eine vorhandene Meßfassung bereits integriert ist und dann nicht mehr als isolierte Schaltung gemessen werden kann. In diesem Fall besteht die Möglichkeit, mittels einer Kalibrierung der inneren und äußeren Tore der Meßfassung und anschließender Quotientenbildung die T-Parameter der Meßfassung zu bestimmen. Durch eine weitere Quotientenbildung zwischen den T-Parametern der Meßfassung mit Zusatznetzwerk und der Meßfassung ohne Zusatznetzwerk kann diese Zusatzschaltung damit isoliert bestimmt werden und dann wieder für die Verknüpfung mit den Systemfehlerkorrekturdaten benutzt werden.

Für die Verknüpfung des beiden Matrizen ist es erforderlich, diese in die gleiche Form zu bringen. Wenn die Systemfehlerkorrekturdaten beispielsweise in Transmissionsmatrixform und die Daten der Zusatzschaltung beispielsweise in Kettenmatrixform vorliegen, wird die Kettenmatrix durch einen Konverter in die Transmissionsmatrixform umgewandelt und dann die beiden gleichartigen Matrizen zu einer neuen Transmissionsparametermatrix verknüpft, die dann wieder in den Speicher des Netzwerkanalysators eingespeichert wird.

Das erfindungsgemäße Verfahren ist auch bei der Entwicklung von Hochfrequenzschaltungen von Vorteil, da hier beliebige Meßobjekte mit beliebigen simulierten Zusatzschaltungen betrieben werden können. Durch entsprechende simulierte Veränderung der Zusatzschaltung kann so die Entwicklung von Schaltungsmodulen oder Bauelementen sehr vereinfacht und erleichtert werden.

Beim erfindungsgemäßen Verfahren ist es auch möglich, die Daten der Zusatzschaltung in aufeinanderfolgenden Messungen zu verändern, um so beispielsweise den Einfluß unterschiedlich dimensionierter Zusatzschaltungen auf das Meßobjekt zu ermitteln. Idealerweise ist die Software für die Bestimmung der Daten des Zusatznetzwerkes auf dem Netzwerkanalysator lauffähig und in einer gemeinsamen Bedienoberfläche des Netzwerkanalysators integriert, so daß der Benutzer des Netzwerkanalysators schnell und einfach das erfindungsgemäße Verfahren ausführen kann.

Die Erfindung wird im folgenden anhand schematischer Zeichnungen an einem Ausführungsbeispiel näher erläutert.

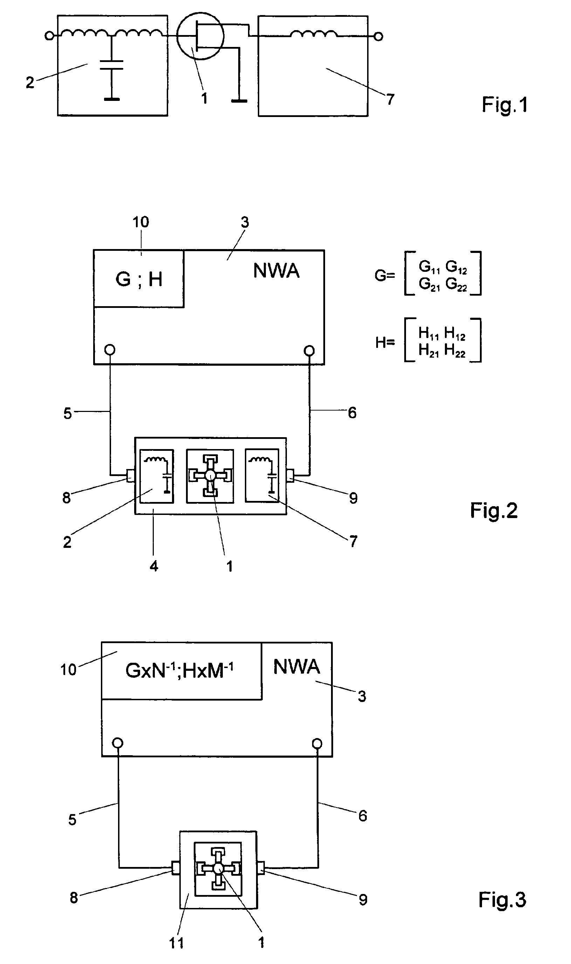

Fig. 1 zeigt das Prinzipschaltbild eines Transistors 1, dem im Betrieb eingangsseitig eine lineare Anpaßschaltung 2 und ausgangsseitig eine Anpaßschaltung 7 zugeschaltet ist. Diese Anpaßschaltungen besitzen neben den berechenbaren Schaltungsteilen parasitäre Effekte, die rechnerisch nicht eindeutig erfaßbar sind. Die Anpaßschaltungen 2 und 7 können also in diesem Beispiel nicht exakt berechnet werden.
Fig. 2 zeigt einen bekannten Meßplatz zum Messen solcher Bauelemente, wie er bei der Wareneingangskontrolle benutzt wird. Der Meßplatz besteht aus einem vektoriellen Netzwerkanalysator 3 und einer Meßfassung 4, die über Koaxialkabel 5 und 6 mit den Meßtoren des Netzwerkanalysators verbunden ist und in die das zu messende Bauelement, beispielsweise der Transistor 1nach Fig. 1 einsetzbar ist. In der Meßfassung 4 sind außerdem die Anpaßschaltungen 2 und 7 eingebaut.

Zur Kalibrierung des Netzwerkanalysators 3 werden zunächst anstelle der Meßobjekts Kalibrierstandards zwischen die Koaxialanschlüsse 8 und 9 geschaltet. Die so gewonnenen Systemfehler-Korrekturdaten werden in einem Speicher 10 des Netzwerkanalysators 3 abgespeichert, beispielsweise in Form von T-Matrizen G und H für die beiden Meßtore. Anschließend wird dann die Meßfassung 4 zwischen die Koaxialanschlüsse 8 und 9 geschaltet und der eingesetzte Transistor 1 zusammen mit den Anpaßschaltungen 2 und 7 gemessen. Auf diese Weise werden nacheinander eine Vielzahl von Transistoren gemessen. Wenn ein anderer Transistortyp gemessen werden soll oder ein Transistor während seines späteren Betriebes mit einer anderen Anpaßschaltung betrieben werden soll muß eine andere Meßfassung 4 mit anderen Anpaßschaltungen 2 und 7 angeschlossen werden. An einem Meßplatz sind daher eine Vielzahl von unterschiedlichen Meßfassungen 4 erforderlich. Wenn in einem Prüffeld beispielsweise 10 solche Meßplätze vorhanden sind muß diese Vielzahl von Meßfassungen auch 10 mal vorhanden sein, noch dazu in relativ engen Toleranzen gleich aufgebaut.
Diese teuere Lagerhaltung von jeweils speziell dimensionierten Meßfassungen 4 wird nach dem erfindungsgemäßen Meßaufbau gemäß Fig. 3 vermieden. Hier ist nur noch eine Universal-Meßfassung 11 vorgesehen, die für alle Meßplätze gleich ist und die auch keine Anpaßschaltungen enthält. Die Meßfassung 11 ist unmittelbar mit dem Netzwerkanalysator 3 verbunden. Die charakteristischen Daten der Anpaßschaltungen werden beim Meßaufbau nach Fig. 3 entweder durch eine vorhergehende Messung oder durch Rechnung bestimmt und mit den Systemfehler-Korrekturdaten des Netzwerkanalysators 3 verknüpft und im Speicher 10 abgespeichert. Wenn die charakteristischen Daten der Anpaßschaltungen als Transmissions-Matrizen für die beiden Meßtore des Netzwerkanalysators mit N und M bezeichnet werden, so kann die Verknüpfung mit den Systemfehlerkorrektur-Matrizen G und H durch einfache Multiplikation der ursprünglichen Fehlerkorrekturmatrizen G und H mit den inversen N- und M-Matrizen der Anpaßschaltungen gewonnen und im Speicher 10 des Netzwerkanalysators abgespeichert werden. Bei der Messung des Transistors 1 an einem Meßplatz gemäß Fig. 3 werden also pro Frequenzpunkt nacheinander an beispielsweise 400 Meßpunkten die jeweiligen rohen Meßwerte des Transistors 1 mit dem im Netzwerkanalysator vorhandenen Algorithmus Systemfehler korrigiert, wobei gleichzeitig die Anpaßschaltung virtuell berücksichtigt wird.

Wenn eine in Fig. 2 gezeigte Meßfassung 4 mit integrierten Anpaßschaltungen 2 und 7 bereits als Muster vorhanden ist so können die charakteristischen Daten dieser Anpaßschaltungen 2 und 7 auf einfache Weise wie folgt bestimmt werden.

Zunächst wird durch Zwischenschalten von Kalibrierstandards zwischen die Koaxialleitungen 5 und 6 der Netzwerkanalysator bezogen auf die äußeren Anschlüsse 8 und 9 der Meßfassung 4 kalibriert. Dann wird gemäß Fig. 2 die Muster-Meßfassung 4 zwischen die Koaxialleitungen 5 und 6 geschaltet und in die später den Transistor aufnehmende Kontaktfassung der Meßfassung 4 werden entsprechende Kalibrierstandards eingelegt. Auf diese Weise werden die Fehlerkorrekturdaten für die inneren Anschlüsse der Meßfassung 4 bestimmt. Dann wird der Quotient zwischen diesen Fehlerkorrekturdaten der äußeren Anschlüsse 8, 9 und der inneren Anschlüsse der Meßfassung 4 gebildet. Anschließend wird gemäß Fig. 3 anstelle der Meßfassung 4 eine Universal-Meßfassung 11 an den Netzwerkanalysator angeschlossen und es wird der Unterschied zwischen den Daten der Meßfassung 4 mit Anpaßnetzwerken 2, 7 und der Meßfassung 11 ohne Anpaßnetzwerk bestimmt. Damit können die charakteristischen Daten der Anpaßnetzwerke 2 und 7 ermittelt werden, die dann mit den Systemfehler-Korrekturdaten des Netzwerkanalysators zu den neuen Fehlerkorrektur-/Simulations-Daten verknüpft werden.

## Patentansprüche

1. Verfahren zum Messen von elektronischen Messobjekten mittels eines Netzwerkanalysators (3), die während ihres Betriebes und damit auch während des Messens in ein lineares Zusatznetzwerk (2,7) einzubetten sind,
**dadurch gekennzeichnet, dass**
a) für den Netzwerkanalysator (3) nach einem bekannten Kalibrierverfahren durch Anschalten von (G;H) Kalibrierstandards Systemfehler-Korrekturdaten (G;H) bestimmt werden,
b) für das zu benutzende lineale Zusatznetzwerk (2,7) dessen charakteristische Daten bestimmt werden und mit den Systemfehler-Korrekturdaten (G;H) nach Merkmal a) zu neuen Fehlerkorrektur-Simulations-Daten (GxN⁻¹; HxM⁻¹) verknüpft werden und
c) diese Fehlerkorrektur-Simulations-Daten (GxN⁻¹; HxM⁻¹) bei der anschließenden Messung von unmittelbar ohne lineales Zusatznetzwerk an den Netzwerkanalysator (3) angeschalteten Messobjekten (1) mit dem im Netzwerkanalysator (3) vorhandenen Algorithmus zur Systemfehlerkorrektur entsprechend berücksichtigt werden, so dass nicht nur eine Systemfehler-Korrektur durchgeführt wird, sondern gleichzeitig ein virtuell mit dem Messobjekt zusammengeschaltetes lineales Zusatznetzwerk simuliert wird.

2. Verfahren nach Anspruch 1,
**dadurch gekennzeichnet,**
**dass** sowohl die Systemfehlerkorrekturdaten (G;H) der Kalibrierstandards als auch die charakteristischen Daten des linearen Zusatznetzwerks in Transmissions (T)-Matrizenform bestimmt und durch Multiplikation zu einer neuen Fehlerkorrektur-Simulations-Matrix (GxN⁻¹; HxM⁻¹) verknüpft werden, die dann im Netzwerkanalysator (3) abgespeichert und bei der anschließenden Messung eines Messobjekts (1) berücksichtigt wird.

3. Verfahren nach Anspruch 1 oder 2,
**dadurch gekennzeichnet,**
**dass** die charakteristischen Daten des linearen Zusatznetzwerkes (2,7) durch Messen an einem konkret aufgebauten Zusatznetzwerk bestimmt werden.

4. Verfahren nach Anspruch 1 oder 2,
**dadurch gekennzeichnet,**
**dass** die charakteristischen Daten des linearen Zusatznetzwerkes (2,7) mit einem an sich bekannten Netzwerksimulationsprogramm berechnet werden.

5. Verfahren nach Anspruch 3 zum Messen von elektronischen Bauelementen, die während der Messung in eine Messfassung eingesetzt werden, in welche ein während des Betriebes der Bauelemente erforderliches Anpassnetzwerk integriert ist,
**dadurch gekennzeichnet, dass**
a) durch ein bekanntes Kalibrierverfahren die Fehlerkorrekturdaten für die inneren und äußeren Anschlüsse der Messfassung bestimmt werden
b) damit die charakteristischen Daten der Messfassung aus dem Unterschied dieser inneren und äußeren Fehlerkorrekturdaten ermittelt werden
c) und schließlich aus dem Unterschied der charakteristischen Daten der Messfassungen mit und ohne Anpassnetzwerk die charakteristischen Daten des Anpassnetzwerks selbst ermittelt werden.

## Claims

1. Method for measuring electronic devices under test by means of a network analyser (3), which are to be embedded, during their operation and therefore also during the measurement, in a linear auxiliary network (2,7),
**characterised in that**
a) system-error correction data (G; H) for the network analyser (3) are determined according to a known calibration method by connecting calibration standards;
b) the characteristic data for the linear auxiliary network (2, 7) to be used are determined and combined with the system-error correction data (G; H) according to feature a) to form new error-correction simulation data (GxN⁻¹; HxM⁻¹); and
c) these error-correction simulation data (GxN⁻¹; HxM⁻¹) are accordingly taken into consideration in the subsequent measurement of devices under test (1) connected directly to the network analyser (3) without linear auxiliary network with an algorithm for system-error correction present in the network analyser (3), so that not only is a system-error correction implemented, but at the same time, a linear auxiliary network connected to the device under test is simulated in a virtual manner.

2. Method according to claim 1,
**characterised in that**
both the system-error correction data (G; H) of the calibration standards and also the characteristic data of the linear auxiliary network are determined in chain-transfer matrix form and combined by multiplication to form a new error-correction simulation matrix (GxN⁻¹; HxM⁻¹), which is then stored in the network analyser (3) and taken into consideration in the subsequent measurement of a device under test (1).

3. Method according to claim 1 or 2,
**characterised in that**
the characteristic data of the linear auxiliary network (2, 7) are determined by measurement of an auxiliary network structured in a concrete manner.

4. Method according to claim 1 or 2,
**characterised in that**
the characteristic data of the linear auxiliary network (2, 7) are calculated with a per se known network simulation program.

5. Method according to claim 3, for measuring electronic components, which are inserted during the measurement into a test device, in which a matching network required during the operation of the components is integrated,
**characterised in that**
a) the error correction data for the internal and external terminals of the test device are determined by a known calibration method;
b) the characteristic data of the test device are therefore determined from the difference between these internal and external error correction data; and
c) the characteristic data of the matching network are themselves finally determined from the difference between the characteristic data of the test devices with and without the matching network.

## Revendications

1. Procédé pour la mesure d'objets électroniques au moyen d'un analyseur de réseau (3) lesquels, pendant son fonctionnement et par conséquent aussi pendant la mesure, sont logés dans un système de réseau supplémentaire linéaire (2, 7),
**caractérisé en ce que**
a) pour l'analyseur de réseau (3), on détermine, selon un procédé de calibrage connu par application de normes de calibrage, des données de correction d'erreur de système (G ; H),
b) pour le réseau supplémentaire linéaire à utiliser dont les données caractéristiques sont déterminées et avec les données de correction d'erreur de système (G ; H) selon la caractéristique a), on effectue une liaison pour de nouvelles données de simulation de correction d'erreur (GxN⁻¹ ; HxM⁻¹) et
c) on prend en considération ces données de simulation de correction d'erreur (GxN⁻¹ ; HxM⁻¹) dans la mesure consécutive des objets appliqués directement sans réseau supplémentaire linéaire sur l'analyseur de réseau (3), avec l'algorithme présent dans l'analyseur de réseau (3) pour la correction d'erreur de système, de sorte que l'on effectue non seulement une correction d'erreur de système mais simultanément aussi une simulation virtuelle avec le réseau supplémentaire linéaire coopérant avec l'objet de mesure.

2. Procédé selon la revendication 1,
**caractérisé en ce que**
aussi bien les données de correction d'erreur de système (G ; H) de la norme de calibrage que les données caractéristiques du réseau supplémentaire linéaire sont déterminées sous la forme de matrices de transfert (T) et sont reliées par multiplication à une nouvelle matrice de simulation de correction d'erreur (GxN⁻¹ ; HxM⁻¹) qui est ensuite stockée dans l'analyseur de réseau et prise en considération dans la mesure consécutive d'un objet (1).

3. Procédé selon la revendication 1 ou 2,
**caractérisé en ce que**
les données caractéristiques du réseau supplémentaire linéaire (2, 7) sont déterminées par mesure sur un réseau supplémentaire configuré de façon concrète.

4. Procédé selon la revendication 1 ou 2,
**caractérisé en ce que**
les données caractéristiques du réseau supplémentaire linéaire (2, 7) sont calculées avec un programme de simulation de réseau connu per se.

5. Procédé selon la revendication 3 pour la mesure d'éléments de construction électroniques qui sont mis en oeuvre pendant la mesure dans une saisie de mesure dans laquelle, pendant le fonctionnement des éléments de construction, est intégré le réseau d'adaptation nécessaire,
**caractérisé en ce que**
a) par un procédé de calibrage connu, on détermine les données de correction d'erreur pour les connexions internes et externes de la saisie de mesure,
b) les données caractéristiques de la saisie de mesure sont ainsi déterminées à partir de la différence de ces données de correction d'erreur internes et externes,
c) et finalement, à partir de la différence des données caractéristiques des saisies de mesure, avec et sans réseau d'adaptation, on détermine les données caractéristiques du réseau d'adaptation lui-même.
